# EUROPÄISCHE PATENTANMELDUNG

(11) **EP 4 203 078 A1**
(43) Veröffentlichungstag der Anmeldung: **28.06.2023**
(21) Anmeldenummer: 23156985.6
(22) Anmeldetag: 31.07.2020
(51) Int. Cl.: H01L 31/0747, H01L 31/18

(54) **RÜCKSEITENEMITTER-SOLARZELLENSTRUKTUR MIT EINEM HETEROÜBERGANG**

(30) Priorität: 05.09.2019 DE 102019123785
(62) Teilanmeldung aus: 20760910.8
(71) Anmelder: Meyer Burger (Germany) GmbH, 09337 Hohenstein-Ernstthal (DE)
(72) Erfinder: Zhao, Jun, 2562 Port (CH); König, Marcel, 09130 Chemnitz (DE)
(74) Vertreter: Steiniger, Carmen

(57) **Zusammenfassung**

Rückseitenemitter-Solarzellenstruktur mit einem Heteroübergang, mit einem Absorber aus einem kristallinen Halbleitersubstrat (2) mit einer Dotierung eines ersten Leitungstyps; einer Vorderseitenintrinsicschicht (4) aus einem intrinsischen, amorphen Halbleitermaterial; einer Rückseitenintrinsicschicht (3) aus einem intrinsischen, amorphen Halbleitermaterial; einer auf der Vorderseitenintrinsicschicht (4) ausgebildeten Vorderseitendotierschicht (5) aus einem amorphen Halbleitermaterial mit einer Dotierung des ersten Leitungstyps; einem Emitter aus einer auf der Rückseitenintrinsicschicht (3) ausgebildeten Rückseitendotierschicht (6) aus einem amorphen Halbleitermaterial mit einer Dotierung eines zweiten Leitungstyps; wobei auf einem Randbereich des Halbleitersubstrates eine Schichtfolge in folgender Reihenfolge von innen nach außen vorliegt: die Rückseitenintrinsicschicht, die Vorderseitenintrinsicschicht, die Vorderseitendotierschicht und die Rückseitendotierschicht (6).

## Beschreibung

Die vorliegende Erfindung betrifft eine Rückseitenemitter-Solarzellenstruktur mit einem Heteroübergang.

Aus der Druckschrift EP 2 682 990 A1 ist ein Verfahren zum Herstellen einer Solarzelle mit einem Heteroübergang und einem Vorderseitenemitter bekannt. Bei dem bekannten Verfahren wird zunächst auf einer Vorderseite eines eine Dotierung eines ersten Leitungstyps aufweisenden Halbleitersubstrates ein Schichtstapel bestehend aus einer vorderseitigen amorphen intrinsischen Halbleiterschicht und einer vorderseitigen amorphen dotierten Halbleiterschicht abgeschieden. Die vorderseitige amorphe dotierte Halbleiterschicht weist eine Dotierung eines zweiten Leitungstyps auf, der entgegengesetzt zu dem ersten Leitungstyp ist. Danach wird auf der Rückseite des Halbleitersubstrates ein Schichtstapel bestehend aus einer rückseitigen amorphen intrinsischen Halbleiterschicht und einer rückseitigen amorphen dotierten Halbleiterschicht abgeschieden. Die rückseitige amorphe dotierte Halbleiterschicht hat eine Dotierung des gleichen Leitungstyps wie das Halbleitersubstrat.

Daraufhin wird auf der Vorderseite eine transparente, elektrisch leitfähige Schicht als Antireflexionsschicht ohne Strukturierung abgeschieden und danach auf der Rückseite über eine Maske eine elektrisch leitfähige Rückseitenbeschichtung aufgebracht, sodass die elektrisch leitfähige Rückseitenbeschichtung nicht auf den an der Substratkante entstandenen Schichtstapel abgeschieden wird und dadurch keine elektrisch leitfähige Schicht am Substratrand elektrisch kontaktiert. Abschließend werden Vorder- und Rückseitenkontakte erzeugt.

Durch diese Schichtaufbringungsreihenfolge entsteht an der Substratseitenkante eine Schichtabfolge mit alternierender Dotierung, also eine n-p-n⁺- oder eine p-n-p⁺-Abfolge mit jeweils darauf befindlicher Antireflexionsschicht. In der Druckschrift EP 2 682 990 A1 wird darauf hingewiesen, dass die beschriebene Schichtabscheidungsreihenfolge unbedingt einzuhalten ist, um eine vorteilhafte Kantenisolierung bei der auszubildenden Solarzelle zu erreichen. Insbesondere ist der Vorderseitenschichtstapel, der aus der vorderseitigen amorphen intrinsischen Halbleiterschicht und der vorderseitigen amorphen dotierten Halbleiterschicht besteht, vor dem Rückseitenschichtstapel, der aus der rückseitigen amorphen intrinsischen Halbleiterschicht und der rückseitigen amorphen dotierten Halbleiterschicht besteht, abzuscheiden, um das Risiko des Entstehens von Nebenschlusswiderständen an der Solarzellenkante zu vermeiden.

Die Druckschrift JP 2001044461 A schlägt zur Vermeidung von unerwünschten Solarzellenkantennebenschlüssen an einer einen Heteroübergang aufweisenden Vorderseitenemitter-Solarzellenstruktur vor, zunächst den aus einer rückseitigen amorphen intrinsischen Halbleiterschicht und einer rückseitigen amorphen dotierten Halbleiterschicht bestehenden Schichtstapel nur auf einem Bereich, der kleiner als der Halbeitersubstratbereich ist, also im Abstand vom Substratrand, abzuscheiden. Erst danach soll der aus einer vorderseitigen amorphen intrinsischen Halbleiterschicht und einer vorderseitigen amorphen dotierten Halbleiterschicht bestehende Schichtstapel auf die Substratvorderseite abgeschieden werden.

Eine ähnliche Verfahrensweise ist auch in der Druckschrift US 2017/0207351 A1 beschrieben.

Die vorliegende Erfindung geht im Gegensatz zu dem oben angeführten Stand der Technik von einer Heteroübergang-Solarzellenstruktur mit einem Rückseitenemitter aus. Derartige Solarzellen besitzen gegenüber Heteroübergang-Solarzellen mit Vorderseitenemitter den Vorteil, dass weniger hohe Anforderungen an die optoelektrischen Eigenschaften der elektrisch leitfähigen, transparenten Vorderseitenleitungsschicht und an das Design der Vorderseitenkontaktierung gestellt werden müssen.

Bei solchen Rückseitenemitter-Heteroübergang-Solarzellen ist es im Stand der Technik üblich, zunächst die Abscheidung der intrinsischen Halbleiterschicht und der mit dem gleichen Leitungstyp wie das Halbleitersubstrat dotierten amorphen Halbleiterschicht auf der für einen Lichteinfall vorgesehenen Substratvorderseite vorzunehmen und erst danach die intrinsische Halbleiterschicht und die anders als das Halbleitersubstrat dotierte amorphe Halbleiterschicht auf der Substratrückseite auszubilden.

Es hat sich jedoch gezeigt, dass bei den bekannten Rückseitenemitter-Heteroübergang-Solarzellen Nebenschlusswiderstand und Rückstrom beträchtliche Werte annehmen können, worunter die Solarzellencharakteristik leidet.

Es ist daher die Aufgabe der vorliegenden Erfindung, die elektrischen Solarzelleneigenschaften von Rückseitenemitter-Heteroübergang-Solarzellen zu verbessern.

Diese Aufgabe wird durch eine Rückseitenemitter-Solarzellenstruktur mit einem Heteroübergang gelöst, bei der an einem Seitenrand der Rückseitenemitter-Solarzellenstruktur, auf einem Randbereich eines kristallinen, eine Dotierung eines ersten Leitungstyps aufweisenden Halbleitersubstrates der Rückseitenemitter-Solarzellenstruktur eine Schichtfolge mit einer doppelten Intrinsicschicht ausgebildet ist.

Die doppelte Intrinsicschicht auf dem Rand bzw. an der Seitenkante des Halbleitersubstrates scheint die ausgebildete Struktur besonders vor einer Ausbildung von Nebenschlusswiderständen und Leckströmen am Solarzellenrand zu schützen.

Vorzugsweise ist die Schichtfolge eine n-i-i-n⁺-p-Schichtfolge oder eine p-i-i-p⁺-n-Schichtfolge.

Bevorzugt weist die doppelte Intrinsicschicht folgende Reihenfolge von innen nach außen auf:
- wenigstens eine Rückseitenintrinsicschicht, und
- darauf wenigstens eine Vorderseitenintrinsicschicht.

Besonders bevorzugt weist die an dem Seitenrand der Rückseitenemitter-Solarzellenstruktur, auf dem Randbereich des Halbleitersubstrates vorliegende Schichtfolge auf der wenigstens einen Vorderseitenintrinsicschicht wenigstens eine Vorderseitendotierschicht aus einem amorphen Halbleitermaterial mit einer Dotierung des ersten Leitungstyps, die höher als die Dotierung des Halbleitersubstrates ist, und auf der wenigstens einen Vorderseitendotierschicht wenigstens eine Rückseitendotierschicht aus einem amorphen Halbleitermaterial mit einer Dotierung eines zweiten Leitungstyps, der entgegengesetzt zu dem ersten Leitungstyp ist, auf.

Zum Herstellen der Rückseitenemitter-Solarzellenstruktur mit dem Heteroübergang wird beispielsweise ein Verfahren verwendet, bei dem
- zur Ausbildung eines Absorbers der Rückseitenemitter-Solarzellenstruktur das kristalline Halbleitersubstrat mit der Dotierung des ersten Leitungstyps bereitgestellt wird;
- auf einer Vorderseite des Halbleitersubstrates wenigstens eine Vorderseitenintrinsicschicht aus einem intrinsischen, amorphen Halbleitermaterial erzeugt wird;
- auf der wenigstens einen Vorderseitenintrinsicschicht wenigstens eine Vorderseitendotierschicht aus einem amorphen Halbleitermaterial mit einer Dotierung des ersten Leitungstyps, die höher als die Dotierung des Halbleitersubstrates ist, erzeugt wird;
- auf einer Rückseite des Halbleitersubstrates wenigstens eine Rückseitenintrinsicschicht aus einem intrinsischen, amorphen Halbleitermaterial erzeugt wird;
- zur Ausbildung eines Emitters der Rückseitenemitter-Solarzellenstruktur auf der wenigstens einen Rückseitenintrinsicschicht wenigstens eine Rückseitendotierschicht aus einem amorphen Halbleitermaterial mit einer Dotierung eines zweiten Leitungstyps, der entgegengesetzt zu dem ersten Leitungstyp ist, erzeugt wird;
- auf der wenigstens einen Vorderseitendotierschicht wenigstens eine elektrisch leitfähige, transparente Vorderseitenleitungsschicht erzeugt wird;
- auf der wenigstens einen Rückseitendotierschicht wenigstens eine elektrisch leitfähige, transparente Rückseitenleitungsschicht erzeugt wird;
- auf der wenigstens einen elektrisch leitfähigen, transparenten Vorderseitenleitungsschicht eine Vorderseitenkontaktierung erzeugt wird; und
- auf der wenigstens einen elektrisch leitfähigen, transparenten Rückseitenleitungsschicht eine Rückseitenkontaktierung erzeugt wird, wobei
die Vorder- und Rückseitenintrinsicschichten und die Vorder- und Rückseitendotierschichten in folgender Reihenfolge erzeugt werden:
- Erzeugen der wenigstens einen Rückseitenintrinsicschicht auf der Rückseite des Halbleitersubstrates;
- dann Erzeugen der wenigstens einen Vorderseitenintrinsicschicht auf der Vorderseite des Halbleitersubstrates;
- dann Erzeugen der wenigstens einen Vorderseitendotierschicht auf der wenigstens einen Vorderseitenintrinsicschicht; und
- dann Erzeugen der wenigstens einen Rückseitendotierschicht auf der wenigstens einen Rückseitenintrinsicschicht.

Überraschenderweise wird dadurch, dass bei dem Verfahren erst die intrinsische amorphe Halbleiterschicht auf der Substratrückseite, also die Rückseitenintrinsicschicht, erzeugt wird, dann die intrinsische amorphe Halbleiterschicht und die dotierte amorphe Halbleiterschicht auf der Substratvorderseite und erst danach die amorphe, anders als das Halbleitersubstrat dotierte Halbleiterschicht, also die Rückseitendotierschicht, auf der Substratrückseite erzeugt werden, der Nebenschlusswiderstand und der Rückstrom bei allen erfindungsgemäß hergestellten Solarzellen deutlich verbessert. Durch thermografische Messungen ist zudem nachgewiesen, dass der Leckstrom über Substratkanten durch die erfindungsgemäße Verfahrensabfolge stark herabgesetzt wird. Außerdem steigt die Qualität der Passivierung der erfindungsgemäß hergestellten Solarzellen, was sich in einer höheren Leerlaufspannung und einem besseren Füllfaktor der Rückseitenemitter-Heteroübergang-Solarzellen zeigt. Darüber hinaus wird durch das erfindungsgemäße Vorgehen die Solarzelleneffizienz gesteigert.

In einer favorisierten Variante des Verfahrens wird als Halbleitersubstrat ein n-dotiertes Halbleitersubstrat verwendet, für das Erzeugen der Vorderseitendotierschicht ein mit Phosphor dotiertes amorphes Halbleitermaterial verwendet und zum Erzeugen der Rückseitendotierschicht ein mit Bor dotiertes amorphes Halbleitermaterial verwendet. Da Bor schneller als Phosphor diffundiert und sich daher schneller als Phosphor in der Anlage zur Herstellung der Rückseitenemitter-Solarzellenstruktur mit Heteroübergang verschleppt, wirkt sich die Abscheidung der Bor-dotierten Rückseitendotierschicht als letzter Schicht bei der Abscheidung der amorphen Schichten besonders positiv auf die Anlagensauberkeit aus.

In einer bevorzugten Ausführungsform des Verfahrens werden das Erzeugen der wenigstens einen Vorderseitenintrinsicschicht auf der Vorderseite des Halbleitersubstrates und das Erzeugen der wenigstens einen Vorderseitendotierschicht auf der wenigstens einen Vorderseitenintrinsicschicht in direkt nacheinander in ein und demselben Schichtabscheidungsreaktor stattfindenden Prozessen vorgenommen. Man braucht hierdurch für die Herstellung der Vorderseitenintrinsicschicht und der Vorderseitendotierschicht nur einen einzigen Schichtabscheidungsreaktor, was insgesamt die Vorrichtung zur Herstellung der Rückseitenemitter-Solarzellenstruktur mit Heteroübergang vereinfacht und kostengünstiger gestaltet.

Zusätzlich ergibt sich eine besonders gute Kantenisolation der erfindungsgemäß hergestellten Rückseitenemitter-Solarzellenstruktur mit Heteroübergang, wenn die wenigstens eine elektrisch leitfähige, transparente Rückseitenleitungsschicht auf der wenigstens einen Rückseitendotierschicht mit einem Abstand zur Seitenkante des Halbleitersubstrates abgeschieden wird, sodass ein Randbereich auf der Rückseite nicht mit der elektrisch leitfähigen, transparenten Rückseitenleitungsschicht beschichtet ist und bei allen Verfahrensschritten zur Ausbildung der elektrisch leitfähigen, transparenten Rückseitenleitungsschicht kein elektrischer Kontakt zwischen der elektrisch leitfähigen, transparenten Rückseitenleitungsschicht und der Vorderseitenleitungsschicht besteht.

Die Rückseitenemitter-Solarzellenstruktur mit einem Heteroübergang weist bevorzugt
- einen Absorber aus dem kristallinen Halbleitersubstrat mit der Dotierung des ersten Leitungstyps;
- wenigstens eine auf einer Vorderseite des Absorbers ausgebildete Vorderseitenintrinsicschicht aus einem intrinsischen, amorphen Halbleitermaterial;
- wenigstens eine auf einer Rückseite des Absorbers ausgebildete Rückseitenintrinsicschicht aus einem intrinsischen, amorphen Halbleitermaterial;
- wenigstens eine auf der wenigstens einen Vorderseitenintrinsicschicht ausgebildete Vorderseitendotierschicht aus einem amorphen Halbleitermaterial mit einer Dotierung des ersten Leitungstyps, die höher als die Dotierung des Absorbers ist;
- einen Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens eine auf der wenigstens einen Vorderseitendotierschicht ausgebildete elektrisch leitfähige, transparente Vorderseitenleitungsschicht;
- wenigstens eine auf der wenigstens einen Rückseitendotierschicht ausgebildete elektrisch leitfähige, transparente Rückseitenleitungsschicht;
- eine auf der wenigstens einen elektrisch leitfähigen, transparenten Vorderseitenleitungsschicht ausgebildete Vorderseitenkontaktierung, und
- eine auf der wenigstens einen elektrisch leitfähigen, transparenten Rückseitenleitungsschicht ausgebildeten Rückseitenkontaktierung auf, wobei
an dem Seitenrand der Rückseitenemitter-Solarzellenstruktur mit dem Heteroübergang, auf dem Randbereich des Halbleitersubstrates eine Schichtfolge in folgender Reihenfolge von innen nach außen vorliegt:
- die wenigstens eine Rückseitenintrinsicschicht,
- darauf die wenigstens eine Vorderseitenintrinsicschicht,
- darauf die wenigstens eine Vorderseitendotierschicht und
- darauf die wenigstens eine Rückseitendotierschicht.

Bedingt durch den Schichtaufbau an dem Seitenrand, also dem Kantenbereich der Rückseitenemitter-Solarzellenstruktur, kommt es zu einer deutlichen Verbesserung des Nebenschlusswiderstandes und des Rückstroms der erfindungsgemäß hergestellten Solarzellen im Vergleich zu Rückseitenemitter-Solarzellenstrukturen, welche an ihrem Seitenrand einen konventionellen Schichtaufbau, bei dem von innen nach außen folgende Schichten in folgender Reihenfolge vorliegen bzw. sich in folgender Reihenfolge überlappen:
- die wenigstens eine Vorderseitenintrinsicschicht,
- darauf die wenigstens eine Vorderseitendotierschicht,
- dann die wenigstens eine Rückseitenintrinsicschicht, und
- darauf die wenigstens eine Rückseitendotierschicht.

Bei einer favorisierten Ausführungsform der erfindungsgemäßen Rückseitenemitter-Solarzellenstruktur mit Heteroübergang ist das Halbleitersubstrat ein n-dotiertes Halbleitersubstrat, die Vorderseitendotierschicht mit Phosphor dotiert und die Rückseitendotierschicht mit Bor dotiert.

Eine vorteilhafte Ausbildung der erfindungsgemäßen Rückseitenemitter-Solarzellenstruktur mit Heteroübergang ist so aufgebaut, dass die wenigstens eine elektrisch leitfähige, transparente Rückseitenleitungsschicht auf der wenigstens einen Rückseitendotierschicht mit einem Abstand zur Seitenkante des Halbleitersubstrates abgeschieden ist, sodass ein Randbereich auf der Rückseite nicht mit der elektrisch leitfähigen, transparenten Rückseitenleitungsschicht beschichtet ist und kein elektrischer Kontakt zwischen der elektrisch leitfähigen, transparenten Rückseitenleitungsschicht und der Vorderseitenleitungsschicht besteht.

Die Rückseitenemitter-Solarzellenstruktur mit Heteroübergang kann durch eine Vorrichtung zur Herstellung einer Rückseitenemitter-Solarzellenstruktur mit einem Heteroübergang, mit
- einem Absorber aus einem kristallinen Halbleitersubstrat mit einer Dotierung eines ersten Leitungstyps;
- wenigstens einer auf einer Vorderseite des Absorbers ausgebildeten Vorderseitenintrinsicschicht aus einem intrinsischen, amorphen Halbleitermaterial;
- wenigstens einer auf einer Rückseite des Absorbers ausgebildeten Rückseitenintrinsicschicht aus einem intrinsischen, amorphen Halbleitermaterial;
- wenigstens einer auf der wenigstens einen Vorderseitenintrinsicschicht ausgebildeten Vorderseitendotierschicht aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht ausgebildeten elektrisch leitfähigen, transparenten Vorderseitenleitungsschicht;
- wenigstens einer auf der wenigstens einen Rückseitendotierschicht ausgebildeten elektrisch leitfähigen, transparenten Rückseitenleitungsschicht;
- einer auf der wenigstens einen Vorderseitenleitungsschicht ausgebildeten Vorderseitenkontaktierung; und
- einer auf der wenigstens einen Rückseitenleitungsschicht ausgebildeten Rückseitenkontaktierung hergestellt werden, wobei
die Vorrichtung zum Erzeugen der wenigstens einen Vorderseitenintrinsicschicht auf der Vorderseite des Halbleitersubstrates, der wenigstens einen Rückseitenintrinsicschicht auf der Rückseite des Halbleitersubstrates, der wenigstens einen Vorderseitendotierschicht auf der wenigstens einen Vorderseitenintrinsicschicht und der wenigstens einen Rückseitendotierschicht auf der wenigstens einen Rückseitenintrinsicschicht nur drei Schichtabscheidungsstränge aufweist, wobei
- ein erster Schichtabscheidungsstrang wenigstens einen Schichtabscheidungsreaktor zum Erzeugen der wenigstens einen Rückseitenintrinsicschicht auf der Rückseite des Halbleitersubstrates aufweist;
- ein zweiter Schichtabscheidungsstrang wenigstens einen Schichtabscheidungsreaktor zum Erzeugen der wenigstens einen Vorderseitenintrinsicschicht auf der Vorderseite des Halbleitersubstrates und zum Erzeugen der wenigstens einen Vorderseitendotierschicht auf der wenigstens einen Vorderseitenintrinsicschicht aufweist; und
- ein dritter Schichtabscheidungsstrang wenigstens einen Schichtabscheidungsreaktor zum Erzeugen der wenigstens einen Rückseitendotierschicht auf der wenigstens einen Rückseitenintrinsicschicht aufweist;
und wobei zwischen dem ersten und dem zweiten Schichtabscheidungsstrang sowie zwischen dem zweiten und dem dritten Schichtabscheidungsstrang wenigstens ein Substrattransport- und -wendesystem vorgesehen ist.

Im Gegensatz zum Stand der Technik durchläuft in der Vorrichtung das Halbleitersubstrat erst den ersten Schichtabscheidungsstrang mit dem wenigstens einen Schichtabscheidungsreaktor zum Erzeugen der wenigstens einen Rückseitenintrinsicschicht, wird dann gewendet, erst danach dem zweiten Schichtabscheidungsstrang mit dem wenigstens einen Schichtabscheidungsreaktor zum Erzeugen der wenigstens einen Vorderseitenintrinsicschicht auf der Vorderseite des Halbleitersubstrates und zum Erzeugen der wenigstens einen Vorderseitendotierschicht auf der wenigstens einen Vorderseitenintrinsicschicht zugeführt, danach wieder gewendet und erst zum Schluss in den dritten Schichtabscheidungsstrang mit dem wenigstens einen Schichtabscheidungsreaktor zum Erzeugen der wenigstens einen Rückseitendotierschicht auf der wenigstens einen Rückseitenintrinsicschicht transportiert.

In einer bevorzugten Ausgestaltung der Vorrichtung weist der erste Schichtabscheidungsstrang einen Rückseitenintrinsicschichtabscheidungsreaktor zum Erzeugen der wenigstens einen Rückseitenintrinsicschicht auf der Rückseite des Halbleitersubstrates auf; weist der zweite Schichtabscheidungsstrang einen einzigen Vorderseitenschichtabscheidungsreaktor zum Erzeugen der wenigstens einen Vorderseitenintrinsicschicht auf der Vorderseite des Halbleitersubstrates und der wenigstens einen Vorderseitendotierschicht auf der wenigstens einen Vorderseitenintrinsicschicht auf; und weist der dritte Schichtabscheidungsstrang einen Rückseitendotierschichtabscheidungsreaktor zum Erzeugen der wenigstens einen Rückseitendotierschicht auf der wenigstens einen Rückseitenintrinsicschicht auf; und ist das wenigstens eine Substrattransport- und -wendesystem vor dem Vorderseitenschichtabscheidungsreaktor vor oder in dem zweiten Schichtabscheidungsstrang vorgesehen.

Bevorzugte Ausführungsformen der vorliegenden Erfindung werden im Folgenden anhand von Figuren näher erläutert, wobei
- die Figuren 1a bis 1i:: schematisch Teilschritte einer Prozessabfolge einer Ausführungsform des Verfahrens zur Herstellung einer Rückseitenemitter-Solarzellenstruktur mit Heteroübergang anhand von Querschnittsansichten der jeweils erzeugten Schichtfolge darstellen;
- Figur 2: schematisch einen an einem Seitenrand eines Zwischenproduktes einer erfindungsgemäßen Rückseitenemitter-Solarzellenstruktur mit Heteroübergang ausgebildeten Schichtstapel nach der Ausbildung der intrinsischen und amorphen Halbleiterschichten zeigt;
- Figur 3: schematisch einen möglichen Grundaufbau eines Teilbereichs einer Vorrichtung zur Herstellung von Rückseitenemitter-Solarzellenstrukturen mit Heteroübergang zeigt; und
- Figur 4: schematisch einen weiteren möglichen Grundaufbau eines Teilbereichs der Vorrichtung zur Herstellung von Rückseitenemitter-Solarzellenstrukturen mit Heteroübergang zeigt.

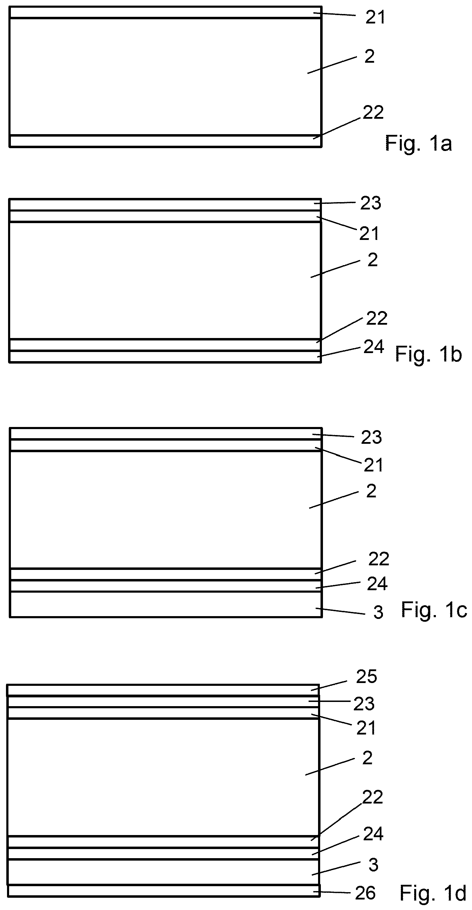

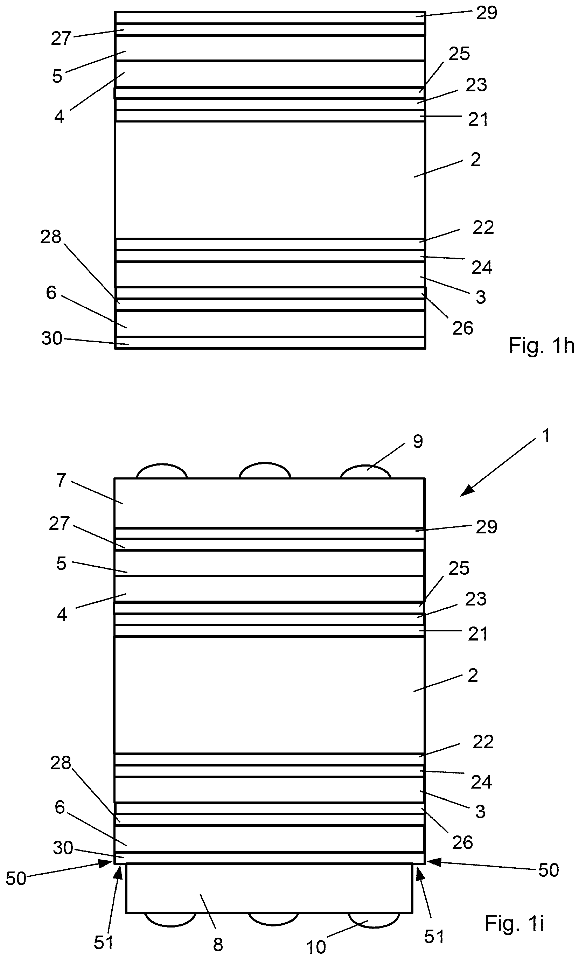

Die Figuren 1a bis 1i zeigen schematisch Teilschritte einer Prozessabfolge einer Ausführungsform des Verfahrens zur Herstellung einer Rückseitenemitter-Solarzellenstruktur 1 mit Heteroübergang, wie sie beispielsweise in Figur 1i schematisch im Querschnitt gezeigt ist, anhand von Querschnittsansichten der jeweils erzeugten Schichtfolge. Dabei sind die Schichtdicken der in den einzelnen Figuren dargestellten Schichten nicht maßstabsgetreu dargestellt. Zwar ist das Verhältnis der jeweiligen Schichtdicken zueinander ebenfalls nicht maßstabsgetreu dargestellt, jedoch ist dann, wenn eine Schicht dünner als eine andere dargestellt ist, diese auch in der Realität typischerweise dünner.

In den Figuren ist die jeweils oben dargestellte Seite der jeweiligen Schichtstruktur die Vorderseite und die unten dargestellte Seite die Rückseite der jeweiligen Schichtstruktur. Die Vorderseite ist die Seite, in die bei der fertigen Rückseitenemitter-Solarzellenstruktur 1 ein Lichteinfall vorgesehen ist.

Figur 1a zeigt schematisch ein kristallines Halbleitersubstrat 2, auf dessen Vorder- und Rückseite Luftoxidschichten 21, 22 ausgebildet sind. Das Halbleitersubstrat 2 weist eine Dotierung eines ersten Leitungstyps auf. In dem gezeigten Ausführungsbeispiel ist das Halbleitersubstrat 2 ein n-dotiertes Siliziumsubstrat, kann aber in anderen Ausführungsformen der Erfindung auch aus einem anderen Halbleitermaterial ausgebildet sein und/oder eine p-Dotierung aufweisen. Vorzugsweise ist die n-Dotierung eine Phosphor-Dotierung, kann aber auch mit wenigstens einem anderen und/oder wenigstens einem zusätzlichen Dotierstoff ausgebildet sein.

Die Luftoxidschichten 21, 22 sind in dem gezeigten Beispiel SiO₂-Schichten mit einer Dicke zwischen 0,2 und 3,0 nm.

Die Luftoxidschichten 21, 22 bilden sich automatisch an der Atmosphäre auf dem vorher gereinigten Halbleitersubstrat 2. Das Halbeitersubstrat 2 bildet bei der fertigen Rückseitenemitter-Solarzellenstruktur 1 einen Absorber aus.

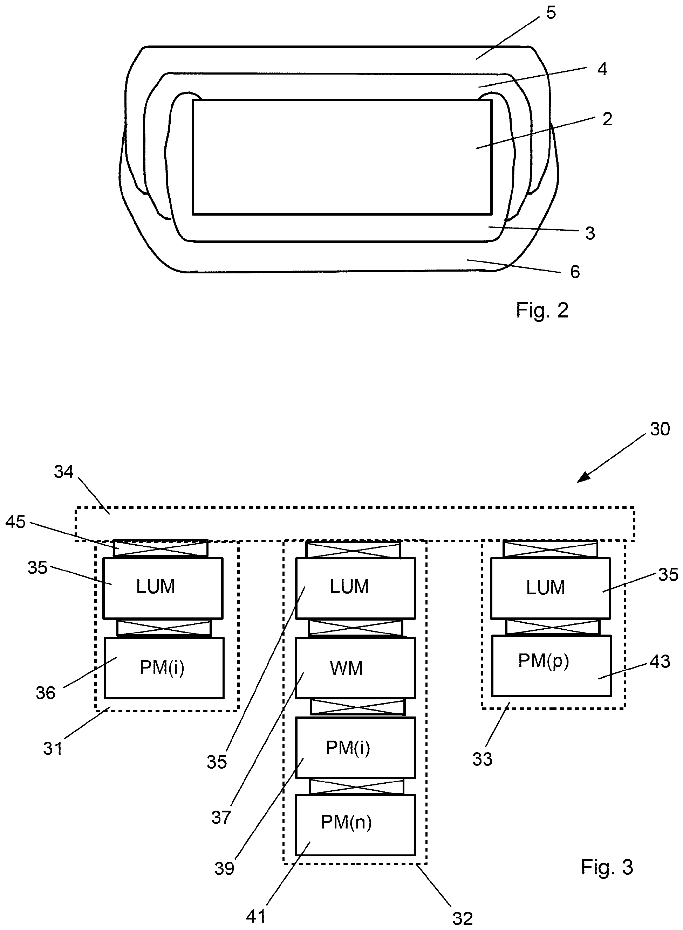

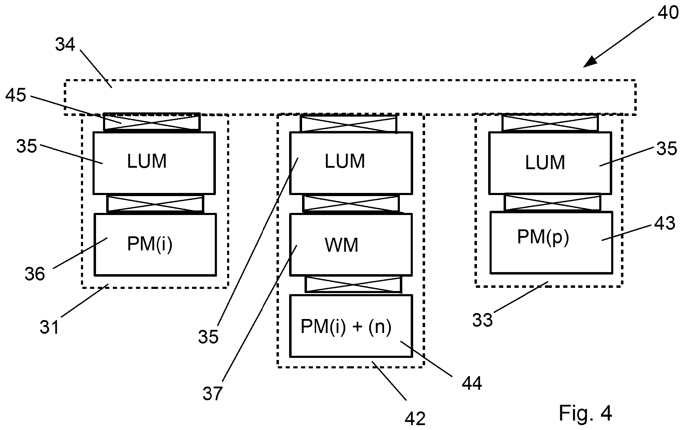

Figur 1b zeigt das Halbleitersubstrat 2 aus Figur 1a nach einem weiteren Verfahrensschritt, in welchem das Halbleitersubstrat 2 in eine Vorrichtung zur Herstellung von Rückseitenemitter-Solarzellenstrukturen 1 mit Heteroübergang geladen wird. Teilbereiche von Beispielen für eine solche Vorrichtungen 30, 40 sind in den Figuren 3 und 4 gezeigt.

Während des Ladens sind beide Seiten des Halbleitersubstrates 2 bei Temperaturen von typischerweise unter 200 °C der Atmosphäre ausgesetzt, sodass sich nochmals Luftoxidschichten 23, 24, also hier SiO₂-Schichten mit einer Dicke von 0,2 bis 3,0 nm, auf der Vorder- und der Rückseite des Halbleitersubstrates 2 ausbilden bzw. die Luftoxidschichten 21, 22 um die Dicke der Luftoxidschichten 23, 24 anwachsen.

In einem weiteren, in Figur 1c schematisch dargestellten Verfahrensschritt des Verfahrens wird auf die Rückseite des die Luftoxidschichten 21, 22, 23, 24 aufweisenden Halbleitersubstrates 2 wenigstens eine Rückseitenintrinsicschicht 3 aus wenigstens einem intrinsischen, amorphen Halbleitermaterial abgeschieden. Die Abscheidung der wenigstens einen Rückseitenintrinsicschicht 3 erfolgt vorzugsweise mit einem PECVD-Verfahren.

In dem in Figur 1d gezeigten Schritt, indem die Schichtstruktur aus Figur 1c zum nächsten Schichtabscheidungsreaktor transportiert und gewendet wird, bilden sich wiederum Luftoxidschichten 25, 26 auf der Vorder- und der Rückseite der Schichtstruktur aus Figur 1c aus. Die Luftoxidschichten 25, 26 sind in dem gezeigten Beispiel SiO₂-Schichten mit einer Dicke von 0,2 bis 3,0 nm. Die Luftoxidschicht 25 wächst direkt auf den auf der Vorderseite bereits bestehenden Luftoxidschichten 21, 23 auf. Die Luftoxidschicht 26 wächst auf der abgeschiedenen Rückseitenintrinsicschicht 3 auf.

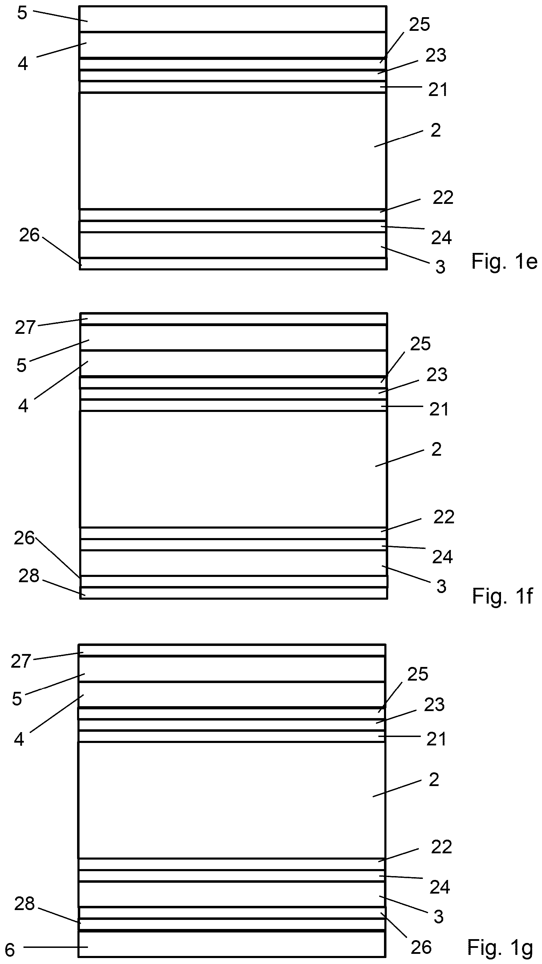

Nach Abscheidung der Rückseitenintrinsicschicht 3 werden auf die Vorderseite des Halbleitersubstrates 2 mit den darauf befindlichen Schichten 21, 23, 25 wenigstens eine Vorderseitenintrinsicschicht 4 aus wenigstens einem amorphen intrinsischen Halbleitermaterial und wenigstens eine Vorderseitendotierschicht 5 aus wenigstens einem amorphen Halbleitermaterial mit einer Dotierung des ersten Leitungstyps, die höher als die Dotierung des Halbleitersubstrates 2 ist, abgeschieden. Dies ist in Figur 1e zu sehen. Da in dem gezeigten Ausführungsbeispiel das Halbleitersubstrat 2 n-dotiert ist, ist hier auch die Vorderseitendotierschicht 5 n-dotiert, vorzugsweise mit Phosphor dotiert.

Die Vorderseitenintrinsicschicht 4 kann separat von der Vorderseitendotierschicht 5, in unterschiedlichen Schichtabscheidungsreaktoren abgeschieden werden. Es ist jedoch besonders von Vorteil, wenn, wie in dem gezeigten Ausführungsbeispiel geschehen, die Vorderseitendotierschicht 5 direkt nach der Vorderseitenintrinsicschicht 4 in ein und demselben Schichtabscheidungsreaktor ohne zwischenzeitliches Substrathandling abgeschieden wird. In diesem Fall wird eine Luftoxidbildung zwischen der Vorderseitenintrinsicschicht 4 und der Vorderseitendotierschicht 5 vermieden.

Bei dem nach dieser Schichtabscheidung bzw. diesen Schichtabscheidungen erforderlichen Substrathandling, während dessen ein Substratransport zum nächsten Schichtabscheidungsreaktor und erneut ein Wenden des Substrates stattfindet, gelangt die erzeugte und in Figur 1e schematisch gezeigte Schichtstruktur erneut an Atmosphäre, wodurch wiederum Luftoxidschichten 27, 28 auf beiden Seiten der Schichtstruktur wachsen, was in Figur 1f gezeigt ist. Die Luftoxidschichten 27, 28 sind in dem Ausführungsbeispiel SiO₂-Schichten mit einer Schichtdicke zwischen 0,2 und 3,0 nm.

Nach einem weiteren Substrathandling wird auf der Rückseite der in Figur 1f gezeigten Schichtanordnung eine Rückseitendotierschicht 6 aus einem amorphen Halbleitermaterial mit einer Dotierung eines zweiten Leitungstyps, der entgegengesetzt zu dem ersten Leitungstyp ist, erzeugt. Dies ist in Figur 1g dargestellt. In dem gezeigten Ausführungsbeispiel ist die Rückseitendotierschicht 6 eine p-dotierte, amorphe Siliziumschicht. Speziell ist die in dem Beispiel verwendete p-Dotierung eine Bor-Dotierung, kann jedoch in anderen Ausführungsbeispielen der Erfindung eine andere Dotierung sein. Die Rückseitendotierschicht 6 bildet nach der darauf vorgesehenen, im nachfolgenden beschriebenen elektrischen Kontaktierung den Emitter der auszubildenden Rückseitenemitter-Solarzellenstruktur 1 mit Heteroübergang.

Die Schichtstruktur aus Figur 1g wird im Folgenden zu wenigstens einem weiteren Schichtabscheidungsreaktor transportiert, wobei die Schichtstruktur während des Transportes erneut Atmosphärenbedingungen ausgesetzt ist. Dabei bilden sich wiederum etwa 0,2 bis 3,0 nm dünne Luftoxidschichten 29, 30 auf der Vorder- und der Rückseite der Schichtstruktur aus, was in Figur 1h zu sehen ist.

Danach werden, wie es in Figur 1i schematisch dargestellt ist, auf der Vorderseite und der Rückseite der Schichtstruktur aus Figur 1h elektrisch leitfähige, transparente Vorder- und Rückseitenleitungsschichten 7, 8 erzeugt. Die elektrisch leitfähigen, transparenten Vorder- und Rückseitenleitungsschichten 7, 8 bestehen vorzugsweise aus elektrisch leitfähigem, transparenten Oxid (TCO). In dem gezeigten Ausführungsbeispiel sind die elektrisch leitfähigen, transparenten Vorder- und Rückseitenleitungsschichten 7, 8 Indium-Zinn-Oxid-Schichten (ITO-Schichten).

Die elektrisch leitfähige, transparente Rückseitenleitungsschicht 8 ist in dem gezeigten Ausführungsbeispiel auf der wenigstens einen Rückseitendotierschicht 6 mit einem Abstand zur Seitenkante 50 des Halbleitersubstrates 2 abgeschieden. Die Abscheidung der Rückseitendotierschicht 6 kann beispielsweise über eine Maske erfolgen. Dadurch bleibt ein Randbereich 51 auf der Rückseite der Rückseitenemitter-Solarzellenstruktur 1 mit Heteroübergang von der elektrisch leitfähigen, transparenten Rückseitenleitungsschicht 8 unbeschichtet. Durch die strukturierte Abscheidung besteht kein elektrischer Kontakt zwischen der elektrisch leitfähigen, transparenten Rückseitenleitungsschicht 8 und der Vorderseitenleitungsschicht 7, auch nicht während der Abscheidung der elektrisch leitfähigen, transparenten Rückseitenleitungsschicht 8.

Abschließend werden jeweils auf den elektrisch leitfähigen, transparenten Vorder- und Rückseitenleitungsschichten 7, 8 Vorderseiten- bzw. Rückseitenkontaktierungen 9, 10 erzeugt. Die Vorderseiten- und Rückseitenkontaktierungen 9, 10 sind in dem gezeigten Ausführungsbeispiel aus Silber ausgebildet und in Fingerform auf der Solarzellenvorderseite und der Solarzellenrückseite vorgesehen. Sie können jedoch auch aus anderem, elektrisch leitfähigen Material ausgebildet sein und/oder in anderer Form aufgebracht sein.

Wie es den obigen Ausführungen entnehmbar ist, entstehen bei jedem Substrattransport Luftoxidschichten 21, 22, 23, 24, 25, 26, 27, 28, 29, 30, welche Barrieren zwischen dem Halbeitersubstrat 2 und den darauf abgeschiedenen Intrinsicschichten 3, 4, zwischen der Rückseitenintrinsicschicht 4 und der Rückseitendotierschicht 6 sowie zwischen den Vorder- und Rückseitendotierschichten 5, 6 und den jeweils darauf abgeschiedenen Vorder- bzw. Rückseitenleitungsschichten 7, 8 ausbilden. Diese Barrieren behindern den Leitungsträgertransport und verschlechtern damit die Solarzelleneigenschaften der auszubildenden Rückseitenemitter-Solarzellenstruktur 1 mit Heteroübergang. Indem, wie oben beschrieben, die Vorderseitendotierschicht 5 direkt nach der Vorderseitenintrinsicschicht 4 in demselben Schichtabscheidungsreaktor abgeschieden wurde, konnte eine solche Barrierenbildung zwischen der Vorderseitenintrinsicschicht 4 und der Vorderseitendotierschicht 5 vermieden werden.

Ferner wird durch die erfindungsgemäße Prozesschrittabfolge, bei der die Bor-dotierte Rückseitendotierschicht 6 als letzte der amorphen Halbleiterschichten abgeschieden wird, die Ausdiffusion von Bor, welches einen höheren Diffusionskoeffizienten als das in der Vorderseitendotierschicht 5 enthaltene Phosphor aufweist, aus der Rückseitendotierschicht 6 auf ein Minimum beschränkt. Auch hierdurch werden die Solarzelleneigenschaften der auszubildenden Rückseitenemitter-Solarzellenstruktur 1 mit Heteroübergang vorteilhaft beeinflusst.

Wie es in Figur 2 schematisch zu sehen ist, hat die erfindungsgemäße Vorgehensweise auch noch weitere vorteilhafte Effekte. In Figur 2 ist schematisch ein Zwischenprodukt der erfindungsgemäßen Rückseitenemitter-Solarzellenstruktur 1 mit Heteroübergang aus Figur 1i gezeigt. Während in den Figuren 1a bis 1i die sich am Solarzellenrand jeweils bildende Schichtfolgen der Übersichtlichkeit halber weggelassen wurden, ist in Figur 2 diese Schichtfolge nach Abscheidung der amorphen Halbleiterschichten 3, 4, 5 und 6 und vor Ausbildung der weiteren Schichten 7, 8, 9, 10 besonders groß dargestellt.

Ausgehend von dem im dargestellten Ausführungsbeispiel n-dotierten Halbleitersubstrat 2 ergibt sich am Solarzellenrand eine n-i-i-n⁺-p-Schichtfolge. Dagegen ergibt sich im Stand der Technik durch die herkömmliche Verfahrensabfolge eine n-i-n⁺-i-p-Schichtfolge. Die doppelte Intrinsicschicht 3, 4 auf dem Rand bzw. an der Seitenkante des Halbleitersubstrates 2 scheint die ausgebildete Struktur besonders vor einer Ausbildung von Nebenschlusswiderständen und Leckströmen am Solarzellenrand zu schützen.

In den Figuren 3 und 4 sind schematisch Teilbereiche möglicher Anlagenkonzepte bzw. Vorrichtungen 30, 40 für die Herstellung von Rückseitenemitter-Solarzellenstrukturen 1 mit Heteroübergang, wie sie oben beschrieben sind, dargestellt. Die Vorrichtung 30, die in Figur 3 bereichsweise schematisch dargestellt ist, als auch die Vorrichtung 40, die in Figur 4 bereichsweise dargestellt ist, weisen jeweils für die Ausbildung der amorphen Halbleiterschichten 3, 4, 5, 6 drei Schichtabscheidungsstränge 31, 32 bzw. 42, 33 auf.

In einem ersten Schichtabscheidungsstrang 31 ist wenigstens ein Schichtabscheidungsreaktor 36 zum Erzeugen der wenigstens einen Rückseitenintrinsicschicht 3 auf der Rückseite des Halbleitersubstrates 2 vorgesehen.

In einem zweiten Schichtabscheidungsstrang 32 bzw. 42 ist wenigstens ein Schichtabscheidungsreaktor 39, 41; 44 zum Erzeugen der wenigstens einen Vorderseitenintrinsicschicht 4 auf der Vorderseite des Halbleitersubstrates 2 und zum Erzeugen der wenigstens einen Vorderseitendotierschicht 5 auf der wenigstens einen Vorderseitenintrinsicschicht 4 vorgesehen. In der Vorrichtung 40 weist der zweite Schichtabscheidungsstrang 42 nur einen einzigen Vorderseitenschichtabscheidungsreaktor 44 zum Erzeugen der wenigstens einen Vorderseitenintrinsicschicht 4 auf der Vorderseite des Halbleitersubstrates 2 und der wenigstens einen Vorderseitendotierschicht 5 auf der wenigstens einen Vorderseitenintrinsicschicht 4 auf.

In einem dritten Schichtabscheidungsstrang 33 ist wenigstens ein Schichtabscheidungsreaktor 43 zum Erzeugen der wenigstens einen Rückseitendotierschicht 6 auf der wenigstens einen Rückseitenintrinsicschicht 3 vorgesehen.

Zwischen dem ersten Schichtabscheidungsstrang 31 und dem zweiten Schichtabscheidungsstrang 32 bzw. 42 sowie zwischen dem zweiten Schichtabscheidungsstrang 32 bzw. 42 und dem dritten Schichtabscheidungsstrang 33 ist jeweils ein Substrattransport- und -wendesystem 37 vorgesehen. Bei den Vorrichtungen 30, 40 ist nur ein einziges Substrattransport- und -wendesystem 37 vorgesehen, welches sich vor dem/den Vorderseitenschichtabscheidungsreaktor(en) 39, 41 bzw. 44 befindet.

Zwischen und vor den einzelnen Schichtabscheidungsreaktoren ist jeweils eine Schleuseneinrichtung 45 vorgesehen.

Zu Beginn jedes Schichtabscheidungsstranges 31, 32 bzw. 42, 33 ist jeweils eine Be- und Entladeeinrichtung 35 vorgesehen.

## Patentansprüche

1. Rückseitenemitter-Solarzellenstruktur (1) mit einem Heteroübergang, **dadurch gekennzeichnet, dass** an einem Seitenrand (50) der Rückseitenemitter-Solarzellenstruktur (1), auf einem Randbereich eines kristallinen, eine Dotierung eines ersten Leitungstyps aufweisenden Halbleitersubstrates (2) der Rückseitenemitter-Solarzellenstruktur (1) eine Schichtfolge mit einer doppelten Intrinsicschicht (3, 4) ausgebildet ist.

2. Rückseitenemitter-Solarzellenstruktur nach Anspruch 1, **dadurch gekennzeichnet, dass** die Schichtfolge eine n-i-i-n⁺-p-Schichtfolge oder eine p-i-i-p⁺-n-Schichtfolge ist.

3. Rückseitenemitter-Solarzellenstruktur nach einem der vorhergehenden Ansprüche, **dadurch gekennzeichnet, dass** die doppelte Intrinsicschicht folgende Reihenfolge von innen nach außen aufweist:
- wenigstens eine Rückseitenintrinsicschicht (3), und
- darauf wenigstens eine Vorderseitenintrinsicschicht (4).

4. Rückseitenemitter-Solarzellenstruktur nach Anspruch 3, **dadurch gekennzeichnet, dass** die an dem Seitenrand (50) der Rückseitenemitter-Solarzellenstruktur (1), auf dem Randbereich des Halbleitersubstrates (2) vorliegende Schichtfolge auf der wenigstens einen Vorderseitenintrinsicschicht (4) wenigstens eine Vorderseitendotierschicht (5) aus einem amorphen Halbleitermaterial mit einer Dotierung des ersten Leitungstyps, die höher als die Dotierung des Halbleitersubstrates (2) ist, und auf der wenigstens einen Vorderseitendotierschicht (5) wenigstens eine Rückseitendotierschicht (6) aus einem amorphen Halbleitermaterial mit einer Dotierung eines zweiten Leitungstyps, der entgegengesetzt zu dem ersten Leitungstyp ist, aufweist.
